# EUROPEAN PATENT SPECIFICATION

(11) **EP 2 120 274 B1**
(45) Date of publication and mention of the grant of the patent: **03.01.2018**
(21) Application number: 09160164.1
(22) Date of filing: 13.05.2009
(51) Int. Cl.: H01L 51/30

(54) **Carbon Nanotube Thin Film Transistor**
Dünnfilmtransistor auf Basis von Kohlenstoffnanoröhrchen
Transistor à base de nanotubes en carbon

(30) Priority: 14.05.2008 CN 200810067163; 14.05.2008 CN 200810067162; 14.05.2008 CN 200810067171; 04.06.2008 CN 200810067639; 16.05.2008 CN 200810067273; 14.05.2008 CN 200810067164; 14.05.2008 CN 200810067172; 16.05.2008 CN 200810067274; 14.05.2008 CN 200810067159; 14.05.2008 CN 200810067160; 30.05.2008 CN 200810067565; 23.05.2008 CN 200810067425; 14.05.2008 CN 200810067161
(43) Date of publication of application: 18.11.2009
(73) Proprietor: Tsing Hua University, Haidian District Beijing (CN); Hon Hai Precision Industry Co., Ltd., Tu-cheng City, Taipei Hsien (TW)
(72) Inventor: Liu, Kai, Tsing Hua University, Beijing (CN); Li, Qun-Qingi, Tsing Hua University, Beijing (CN); Wang, Xue-Shen, Tsing Hua University, Beijing (CN); Liu, Chang-Hong, Tsing Hua University, Beijing (CN); Fang, Shou-Shan, Tsing Hua University, Beijing (CN); Jiang, Kai-Li, Tsing Hua University, Beijing (CN)
(74) Representative: Murgitroyd & Company

(56) References cited:
- EP-A1- 1 679 752
- WO-A1-2006/085559
- WO-A1-2007/099975
- US-A1- 2004 023 514
- US-A1- 2005 110 064
- US-A1- 2006 194 058
- US-A1- 2007 026 646
- US-A1- 2007 069 212
- US-A1- 2008 102 017
- KANG S J ET AL: "High-performance electronics using dense, perfectly aligned arrays of single-walled carbon nanotubes", NATURE NANOTECHNOLOGY, NATURE PUBLISHING GROUP, LONDON, GB, vol. 2, 25 March 2007 (2007-03-25), pages 230-236, XP002464500,
- WONG H-S P ET AL: "Carbon nanotube field effect transistors - fabrication, device physics, and circuit implications", SOLID-STATE CIRCUITS CONFERENCE, 2003. DIGEST OF TECHNICAL PAPERS. ISS CC. 2003 IEEE INTERNATIONAL SAN FRANCISCO, CA, USA 9-13 FEB. 2003, PISCATAWAY, NJ, USA,IEEE, US, 9 February 2003 (2003-02-09), pages 1-10, XP010661543, ISBN: 978-0-7803-7707-3
- ARTUKOVIC E ET AL: "Transparent and flexible carbon nanotube transistors", NANO LETTERS, ACS, WASHINGTON, DC, US, vol. 5, no. 4, 3 August 2005 (2005-08-03), pages 757-760, XP002463118, ISSN: 1530-6984, DOI: DOI:10.1021/NL050254O
- PIMPARKAR N ET AL: "Current-Voltage Characteristics of Long-Channel Nanobundle Thin-Film Transistors: A Bottom-Up Perspective", IEEE ELECTRON DEVICE LETTERS, IEEE SERVICE CENTER, NEW YORK, NY, US, vol. 28, no. 2, 1 February 2007 (2007-02-01), pages 157-160, XP011157703, ISSN: 0741-3106, DOI: DOI:10.1109/LED.2006.889219
- BRADLEY K ET AL: "FLEXIBLE NANOTUBE ELECTRONICS", NANO LETTERS, ACS, WASHINGTON, DC, US, vol. 3, no. 10, 1 October 2003 (2003-10-01), pages 1353-1355, XP008037744, ISSN: 1530-6984, DOI: DOI:10.1021/NL0344864
- SNOW E ET AL: "High-mobility carbon-nanotube thin-film transistors on a polymeric substrate", APPLIED PHYSICS LETTERS, AIP, AMERICAN INSTITUTE OF PHYSICS, MELVILLE, NY, US, vol. 86, no. 3, 11 January 2005 (2005-01-11), pages 33105-033105, XP012066128, ISSN: 0003-6951, DOI: DOI:10.1063/1.1854721
- Marcus D. Lay ET AL: "Simple Route to Large-Scale Ordered Arrays of Liquid-Deposited Carbon Nanotubes", Nano Letters, vol. 4, no. 4, 1 April 2004 (2004-04-01), pages 603-606, XP055046938, ISSN: 1530-6984, DOI: 10.1021/nl035233d

## Description

The present disclosure relates to thin film transistors.

A typical thin film transistor (TFT) is made of a substrate, a gate electrode, an insulation layer, a drain electrode, a source electrode, and a semiconducting layer. The thin film transistor performs a switching operation. In use, the thin film transistor modulates carriers in an interface between the insulation layer and the semiconducting layer from an accumulation state to a depletion state, with voltage applied to the gate electrode. Thus, the thin film transistor can change the amount of the current passing between the drain electrode and the source electrode. In practical use, a high carrier mobility affect of the material of the semiconducting layer of the thin film transistor is desired.

Previously, the material of the semiconducting layer has been selected from amorphous silicone (a-Si), poly-silicone (p-Si), or organic semiconducting material. The carrier mobility of an a-Si thin film transistor is relatively lower than a p-Si thin film transistor. However, the method for making the p-Si thin film transistor is complicated and has a high cost. The organic thin film transistor is flexible but has low carrier mobility.

Carbon nanotubes (CNTs) are a novel carbonaceous material and have received a great deal of interest since the early 1990s. Carbon nanotubes have interesting and potentially useful heat conducting, electrical conducting, and mechanical properties. Further, there are two kinds of carbon nanotubes: metallic carbon nanotubes and semiconducting carbon nanotubes determined by the arrangement of the carbon atoms therein. The carrier mobility of semiconducting carbon nanotubes along a length direction thereof can reach about 1000 to 1500 cm²V⁻¹s⁻¹. Thus the thin film transistor adopting carbon nanotubes as a semiconducting layer has been produced. In Kang S J et al: "High-performance electronics using dense, perfectly aligned arrays of single-walled carbon nanotubes", NATURE NANOTECHNOLOGY, NATURE PUBLISHING GROUP, LONDON, GB, vol. 2, 25 March 2007 (2007-03-25), pages 230-236, XP002464500, a thin film transistor with a semiconducting layer comprises a carbon nanotube array. The carbon nanotubes in the carbon nanotube array are oriented from the source electrode to the drain electrode of the thin film transistor. The carbon nanotubes in Kang S J *et al* are obtained by a CVD method and are aligned side-by-side. Because the carbon nantoubes obtained by the CVD method have the same length, the carbon nanotube array has a same length with the carbon nanotubes at the longest 100 microns which limits the application of the thin film transistor. In US-A-2008/102017, a single wall carbon nanotube thin film transistor comprises a channel with heterojunctions. The heterojunction is formed by introducing a defect during the growth of the single-wall carbon-nanotubes according to the selection of growth conditions and the like and introducing a five-membered ring or a seven-membered ring into a six-membered ring structure of the graphene sheet. Therefore a metallic and a semiconducting carbon nanotube part are connected to each other by covalent bonds which are chemical bonds to form the heterojunction. In Wong H-S P et al: "Carbon nanotube field effect transistors fabrication, device physics, and circuit implications", SOLID-STATE CIRCUITS CONFERENCE, 2003. DIGEST OF TECHNICAL PAPERS. ISS CC. 2003 IEEE INTERNATIONAL SAN FRANCISCO, CA, USA 9-13 FEB. 2003, PISCATAWAY, NJ, USA,IEEE, US, 9 February 2003 (2003-02-09), pages 1-10, XP010661543, ISBN: 978-0-7803-7707-3, US-A-2004/023514, EP-A-1679752 and EP-A-1679752, thin film transistors with a semiconducting layer comprising a carbon nanotube layer are provided. In Artukovic E et al: "Transparent and flexible carbon nanotube transistors", NANO LETTERS, ACS, WASHINGTON, DC, US, vol. 5, no. 4, 3 August 2005 (2005-08-03), pages 757-760, XP002463118, ISSN: 1530-6984, 001: 001:10.1021 INL0502540, US2006/194058, Pimparkar N et al: "Current-Voltage Characteristics of LongChannel Nanobundle Thin-Film Transistors: A Bottom-Up Perspective" , IEEE ELECTRON DEVICE LETTERS, IEEE SERVICE CENTER, NEW YORK, NY, US, vol. 28, no. 2,1 February 2007 (2007-02-01), pages 157-160, XP011157703, ISSN: 0741-3106, 001: 001:10.11 09/LED.2006.889219, Bradley K et al: "Flexible Nanotube Electronics", NANO LETTERS, ACS, WASHINGTON, DC, US, vol. 3, no. 10, 1 October 2003 (2003-10-01), pages 1353-1355, XP008037744, ISSN: 1530-6984, 001: 001:10.1021 INL0344864 and Snow E et al: "High-mobility carbon-nanotube thin-film transistors on a polymeric substrate", APPLIED PHYSICS LETTERS, AlP, AMERICAN INSTITUTE OF PHYSICS, MELVILLE, NY, US, vol. 86, no. 3, 11 January 2005 (2005-01-11), pages 33105-033105, XP012066128, ISSN: 0003-6951, 001: 001:10.1063/1.1854721, thin film transistors comprise a semiconducting layer which is an isotropic carbon nanotube layer. In US-A-2007/069212 and US-A-2007/026646, thin film transistor panels comprise a semiconducting layer which comprises a semiconducting carbon nanotube layer. US2005/110064 discloses a thin film including a plurality of nanowires parallel to each other and oriented along a same direction. In WO-A-2007/099975, a method for making carbon naotube film with carbon nanotubes aligned along a same direction is provided. WO-A-2007/099975 does not disclose that the carbon nanotube film can be used as a semiconducting layer or the relationship between the aligned carbon nanotubes and the electrodes of thin film transistor. In Marcus D Lay et al: "Simple Route to Large-Scale Ordered Arrays of Liquid-Deposited Carbon Nanotubes", Nano Letters Vol 4, No 4. 603-606, a thin film transistor with semiconducting layer comprises carbon nanotubes aligned along a same direction. The on/off ratio of the thin film transistor is relatively low.

A conventional thin film transistor based on the carbon nanotubes is generally made by the method of printing the mixture of carbon nanotubes and a polymer on a substrate to form a semiconducting layer. There are some problems in the method of fabricating the thin film transistor adopting carbon nanotubes as a semiconducting layer. Firstly, the carbon nanotubes are prone to aggregate in the mixture. Thus, the carbon nanotubes cannot be uniformly dispersed in the carbon nanotube layer. Secondly, the organic solvent is hard to eliminate from the carbon nanotube layer. Thus, impurities may exist in the carbon nanotube layer. Thirdly, the carbon nanotubes in the carbon nanotube layer lack high carrier mobility and cannot be well used in the thin film transistor. Additionally, the carbon nanotube layer formed by the printing method is inflexible. Accordingly, the thin film transistor is inflexible.

What is needed, therefore, is providing a thin film transistor that has high carrier mobility and is flexible.

A thin film transistor according to the present invention comprises a source electrode, a drain electrode, a semiconducting layer, an insulating layer, and a gate electrode. The drain electrode is spaced from the source electrode. The semiconducting layer is electrically connected to the source electrode and the drain electrode. The gate electrode is insulated from the source electrode, the drain electrode, and the semiconducting layer by the insulating layer. The semiconducting layer comprises a carbon nanotube layer. The carbon nanotube layer comprises at least one carbon nanotube film comprising a plurality of successively oriented carbon nanotube segments joined end-to-end by Van der Waals attractive force therebetween, wherein the carbon nanotube segments consist of the plurality of carbon nanotubes, wherein the carbon nanotubes have substantially the same length, and adjacent carbon nanotubes of the carbon nanotube segments are combined side by side by Van der Waals attractive force therebetween, wherein the carbon nanotubes in the at least one carbon nanotube film are oriented along a direction from the source electrode to the drain electrode.

Many aspects of the present thin film transistor can be better understood with references to the following drawings. The components in the drawings are not necessarily drawn to scale, the emphasis instead being placed upon clearly illustrating the principles of the present thin film transistor and the related methods for fabricating the thin film transistor, and a thin film transistor panel using the same.
FIG 1 is a cross sectional view of a thin film transistor in accordance with a first embodiment.
FIG. 2 shows a Scanning Electron Microscope (SEM) image of a carbon nanotube film containing semiconducting carbon nanotubes used in the thin film transistor of FIG. 1.
FIG. 3 is a schematic of a carbon nanotube segment.
FIG. 4 is a SEM image of at least two stacked carbon nanotube film containing semiconducting carbon nanotubes used in the thin film transistor of FIG 1.
FIG. 5 shows a SEM image of a carbon nanotube film segment used in the thin film transistor of FIG 1.
FIG. 6 shows a SEM image of a carbon nanotube structure that can be utilized in the thin film transistor.
FIG 7 is a cross sectional view of a semiconducting layer formed by a carbon nanotube array of the thin film transistor.
FIG. 8 shows a-SEM image of a carbon nanotube film used in the thin film transistor of FIG. 1.
FIG. 9 shows a SEM image of an untwisted carbon nanotube wire used in the thin film transistor of FIG. 1.
FIG. 10 shows a SEM image of a twisted carbon nanotube wire used in the thin film transistor of FIG. 1.
FIG 11 is a flow chart of a method for making the thin film transistor.
FIG. 12 is a process flow chart of the method for making the thin film transistor of FIG. 1.

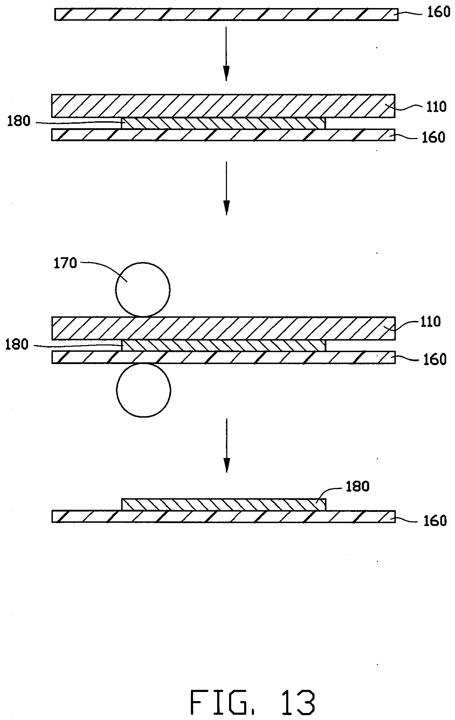

FIG. 13 is a process flow chart of the method for transfer-printing the carbon nanotube layer on the insulating substrate.
FIG. 14 is a schematic view of the thin film transistor of FIG. 1 electrically connected to a circuit.

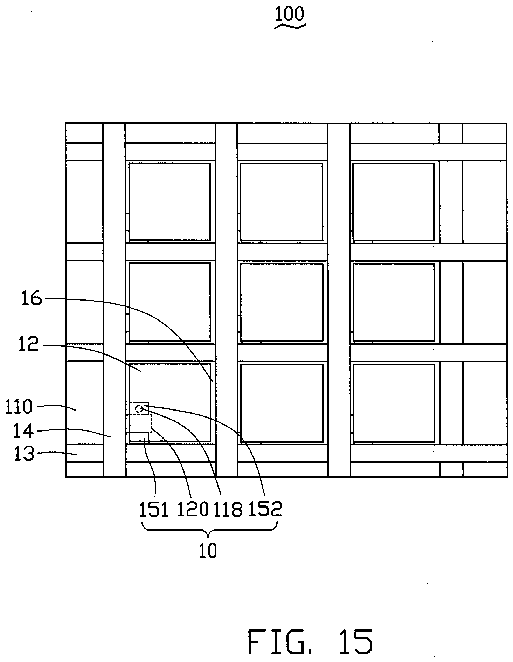

FIG. 15 is a top view of a thin film transistor panel including the thin film transistor of FIG. 1.

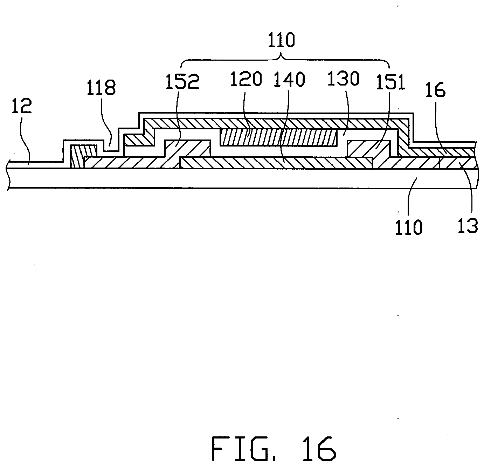

FIG. 16 is a cross sectional view of the thin film transistor panel, taken along a line II-II of FIG. 15.

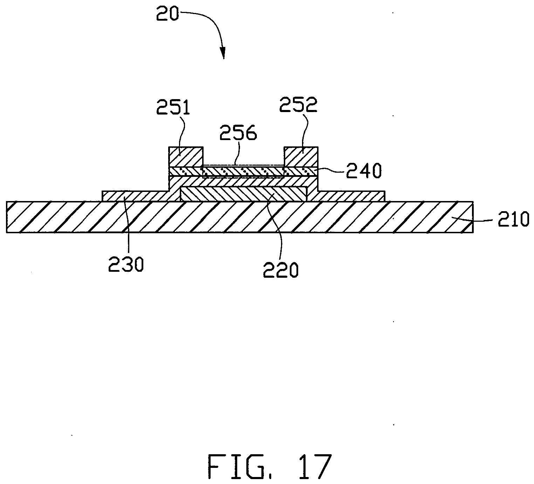

FIG. 17 is a cross sectional view of a thin film transistor in accordance with a second embodiment.

Corresponding reference characters indicate corresponding parts throughout the several views. The exemplifications set out herein illustrate at least one embodiment of the present thin film transistor and the related methods for fabricating the thin film transistor, and the thin film transistor panel using the same, in at least one form, and such exemplifications are not to be construed as limiting the scope of the invention in any manner.

References will now be made to the drawings to describe, in detail, embodiments of the present thin film transistor and the present thin film transistor panel using the same, and the method for making the thin film transistor.

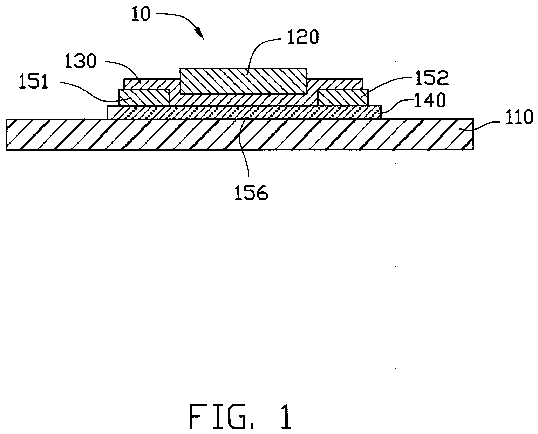

Referring to FIG. 1, a thin film transistor 10 according to a first embodiment is shown. The thin film transistor 10 includes a semiconducting layer 140, a source electrode 151, a drain electrode 152, an insulating layer 130, and a gate electrode 120. The thin film transistor 10 is located on an insulating substrate 110. It should be noted that the thin film transistor 10 has a top gate structure.

The semiconducting layer 140 is located on the insulating substrate 110. The source electrode 151 and the drain electrode 152 are connected to the semiconducting layer 140 and spaced from each other in a certain distance. The insulating layer 130 is located between the semiconducting layer 140 and the gate electrode 120. The insulating layer 130 is located at least on the semiconducting layer 140, or covers at least part of the semiconducting layer 140, the source electrode 151, and the drain electrode 152. The gate electrode 120 is located on the insulating layer 130. The gate electrode 120 is located on the semiconducting layer 140 and insulated from the semiconducting layer 140, the source electrode 151, and the drain electrode 152 by the insulating layer 130. A channel 156 is defined in the semiconducting layer 140 at a region between the source electrode 151 and the drain electrode 152.

The source electrode 151 and the drain electrode 152 can be located on the semiconducting layer 140 or on the insulating substrate 110. More specifically, the source electrode 151 and the drain electrode 152 can be located on a top surface of the semiconducting layer 140, and on a same side of the semiconducting layer 140 as the gate electrode 120. In other embodiments, the source electrode 151 and the drain electrode 152 can be located on the insulating substrate 110 and covered by the semiconducting layer 140. The source electrode 151 and the drain electrode 152 are located on different sides of the semiconducting layer 140. In other embodiments, the source electrode 151 and the drain electrode 152 can be formed on the insulating substrate 110, and coplanar with the semiconducting layer 140.

The insulating substrate 110 is provided for supporting the thin film transistor 10. The material of the insulating substrate 110 can be the same as a substrate of a printed circuit board (PCB), and can be selected from rigid materials (e.g., p-type or n-type silicon, silicon with an silicon dioxide layer formed thereon, crystal, crystal with a oxide layer formed thereon), or flexible materials (e.g., plastic or resin). In the present embodiment, the material of the insulating substrate is glass. The shape and size of the insulating substrate 110 is arbitrary. A plurality of thin film transistors 10 can be located on one insulating substrate 110 to form a thin film transistor panel.

The material of the semiconducting layer 140 can be selected from a group consisting of amorphous silicone (a-Si), poly-silicone (p-Si), organic semiconducting material, or semiconducting carbon nanotubes. In the present embodiment, the semiconducting layer 140 is a semiconducting carbon nanotube layer. The semiconducting carbon nanotube layer includes a plurality of single-walled carbon nanotubes, double-walled carbon nanotubes, or combination thereof. A diameter of the single-walled carbon nanotubes is in the range from 0.5 nanometers to 50 nanometers. A diameter of the double-walled carbon nanotubes is in the range from 1.0 nanometer to 50 nanometers. In the present embodiment, the diameter of the semiconducting carbon nanotubes is less than 10 nanometers.

The semiconducting carbon nanotube layer includes one carbon nanotube film or at least two stacked carbon nanotube films. The carbon nanotube film is formed by a plurality of carbon nanotubes having a uniform thickness, the carbon nanotubes in the carbon nanotube film can be orderly arranged or non-systematically arranged. The carbon nanotube film can be an ordered film or a disordered film.

In the ordered film, the carbon nanotubes are primarily oriented along a same direction in each film and parallel to a surface of the carbon nanotube film. Different stratums/layers of films can have the direction of the nanotubes offset from the nanotubes in other films. More specifically, the ordered carbon nanotube film can include ultra-long carbon nanotubes or can be a "drawn" carbon nanotube film which is drawn from a carbon nanotube array. The drawn carbon nanotube film includes a plurality of semiconducting carbon nanotubes joined end to end by van der Waals attractive force therebetween.

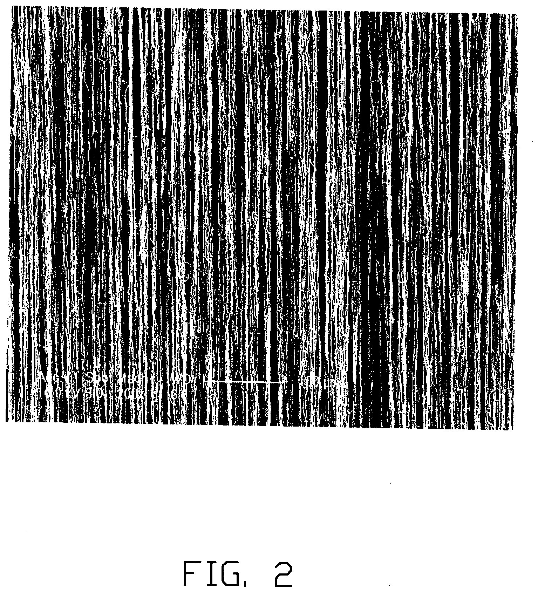

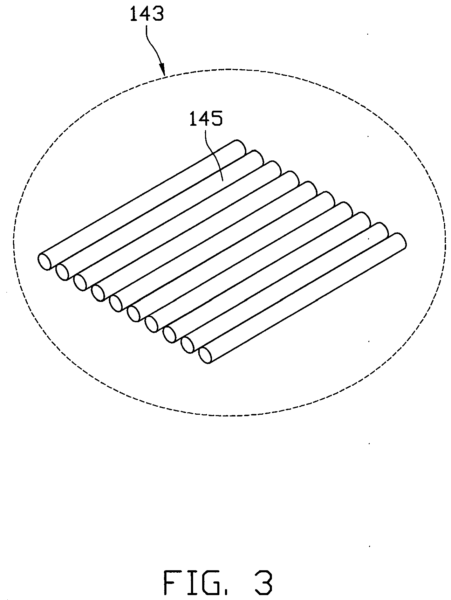

Referring to FIGS. 2 and 3, the drawn carbon nanotube film includes a plurality of successively oriented carbon nanotube segments 143 joined end-to-end by van der Waals attractive force therebetween. Each carbon nanotube segment 143 includes a plurality of carbon nanotubes 145 parallel to each other, and combined by van der Waals attractive force therebetween. The carbon nanotube segments 143 can vary in width, thickness, uniformity and shape. The carbon nanotubes 145 in the carbon nanotube segments 143 are also oriented along a preferred orientation.

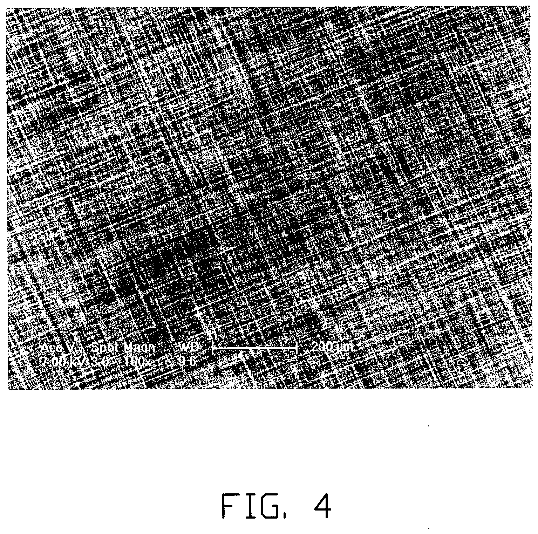

Referring to FIGS. 4, the semiconducting carbon nanotube layer includes at least two stacked carbon nanotube films. Each carbon nanotube film of the semiconducting carbon nanotube layer is formed by a plurality of carbon nanotubes primarily oriented along a same direction in each film. The carbon nanotubes in at least two stacked carbon nanotube films can be aligned along different directions. The carbon nanotube film includes a plurality of successive and oriented semiconducting carbon nanotubes joined end to end by van der Waals attractive force. The adjacent carbon nanotube films are combined by van der Waals attractive force therebetween. An angle α exists between the aligned directions of the carbon nanotubes in two adjacent carbon nanotube films. The angle α ranges from 0 degree to 90 degrees. The carbon nanotubes in at least one carbon nanotube film of the semiconducting layer 140 are oriented along a direction from the source electrode 151 to the drain electrode 152.

The carbon nanotube layer can also includes a plurality of stacked and ordered carbon nanotube films, the carbon nanotubes in different carbon nanotube films can be aligned along a same direction. In the carbon nanotube layer, at least a part of the carbon nanotubes are substantially oriented to one direction from the source electrode 151 to the drain electrode 152. Each carbon nanotube film includes a plurality of semiconducting carbon nanotubes joined end to end by van der Waals attractive force therebetween. In the carbon nanotube layer, at least a part of the carbon nanotubes are substantially oriented to one direction from the source electrode 151 to the drain electrode 152. In the present embodiment, the carbon nanotubes in the carbon nanotube layer are all aligned along the direction from the source electrode 151 to the drain electrode 152. The adjacent carbon nanotubes are combined by van der Waals attractive force therebetween.

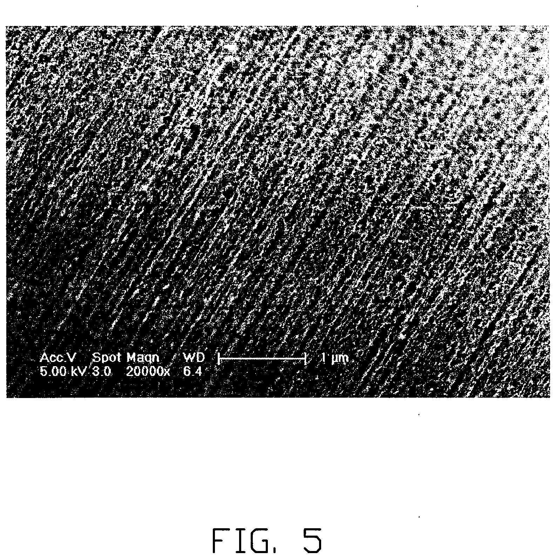

Referring to FIG. 5, the carbon nanotube film includes a plurality of ultra-long semiconducting carbon nanotubes arranged along a preferred orientation. The ultra-long semiconducting carbon nanotubes have lengths of 10 centimeters or greater, comparing with the normal carbon nanotubes which have lengths of several nanometers to several micron meters. The carbon nanotubes are parallel with each other, have almost equal length and are combined side by side by van der Waals attractive force therebetween. A length of the carbon nanotubes can reach up to several millimeters. The length of the film can be equal to the length of the carbon nanotubes. Such that at least one carbon nanotube will span the entire length of the carbon nanotube film. The length of the carbon nanotube film is only limited by the length of the carbon nanotubes.

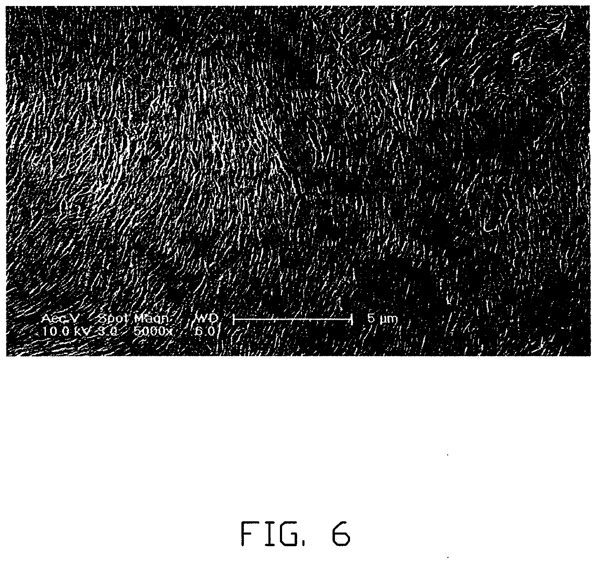

Referring to FIG. 6, the carbon nanotube layer can be a free-standing carbon nanotube film that includes a plurality of disordered semiconducting carbon nanotubes. Further, the free-standing carbon nanotube film is isotropic. The semiconducting carbon nanotubes in the carbon nanotube layer are disordered, and are entangled together by van der Waals attractive force therebetween. The tangled semiconducting carbon nanotubes form a network structure. The network structure includes a plurality of micropores formed by the disordered semiconducting carbon nanotubes. Thus, the thin film transistor 10 using the carbon nanotube layer as semiconducting layer 140 will have a high light transmittance. The diameter of the micropores is less than 50 microns. A thickness of the carbon nanotube layer ranges from 0.5 nanometers to 100 microns. The diameter of the semiconducting carbon nanotube is less than 2 nanometers.

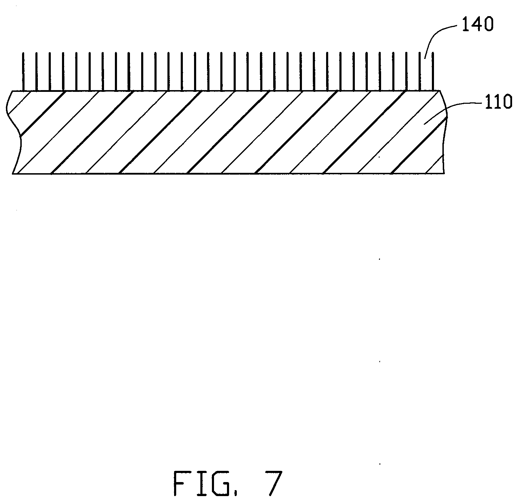

Referring to FIG. 7, the carbon nanotube layer can be a carbon nanotube array that includes a plurality of ordered semiconducting carbon nanotubes. The carbon nanotubes are perpendicular to the insulating substrate 110. A thickness of the semiconducting carbon nanotube layer ranges from 0.5 nanometers to 100 microns. The diameter of the semiconducting carbon nanotubes is less than 2 nanometers.

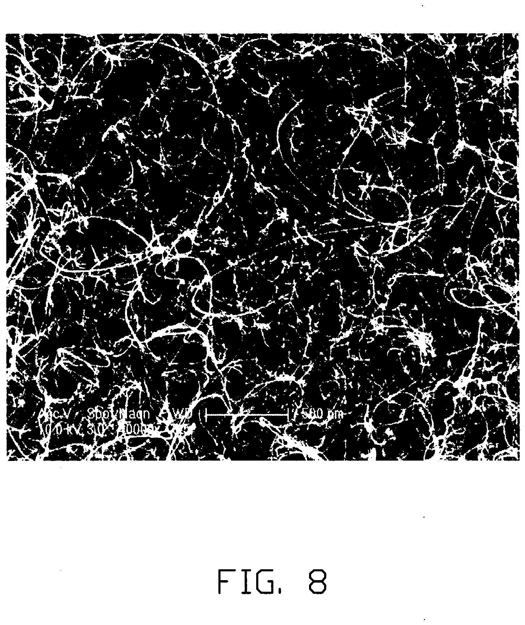

Referring to FIG. 8, the carbon nanotube layer can be a pressing carbon nanotube film comprised of semiconducting carbon nanotubes. The carbon nanotubes in the pressing carbon nanotube film are arranged along a same direction or arranged along different directions. The pressing carbon nanotube film can be connected to the source electrode 151 and the drain electrode 152. The carbon nanotubes in the pressing carbon nanotube film can rest upon each other. Adjacent carbon nanotubes are attracted to each other and combined by van der Waals attractive force. There is an angle exist between each carbon nanotube of the pressing carbon nanotube film and a surface of the semiconducting layer, and the angle ranges from 0 degrees to 15 degrees. In one embodiment, when the carbon nanotubes in the pressing carbon nanotube film are arranged along different directions, the pressing carbon nanotube film can be isotropic. The carbon nanotubes in the pressing carbon nanotube film are semiconducting carbon nanotubes.

The semiconducting layer 140 can also includes a plurality of carbon nanotube wires. Opposite ends of at least some of the plurality of carbon nanotube wires are connected to the source electrode 151 and the drain electrode 152. The arrangement of the carbon nanotube wires can vary according to the practice requirements. One end of each carbon nanotube wire is connected to the source electrode, and opposite end of each the carbon nanotube wire is connected to the drain electrode The carbon nanotube wires can parallel to each other or cross with each other. In this embodiment, the carbon nanotube wires are parallel to and in contact with each other, and the carbon nanotube wires are aligned along a direction extending from the source electrode 151 to the drain electrode 152.

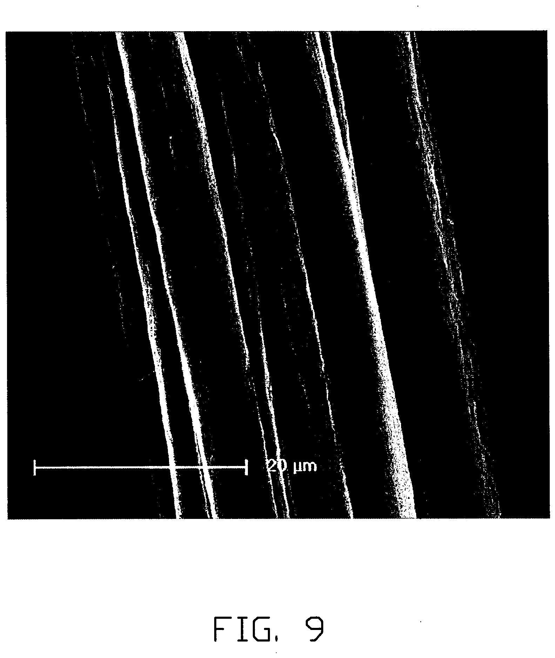

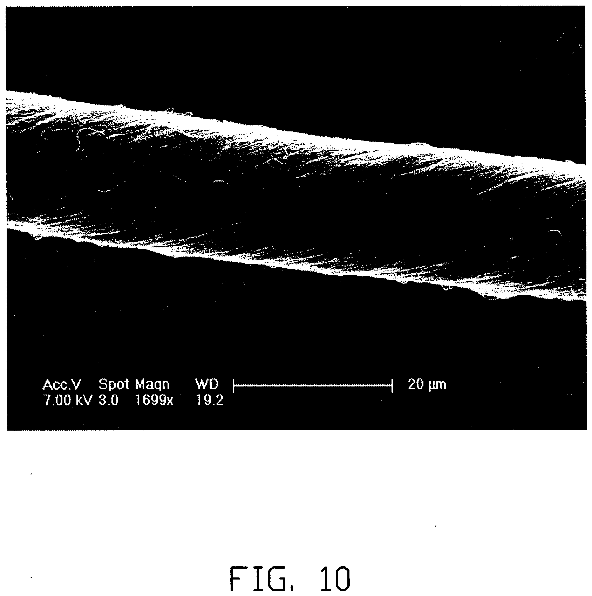

The carbon nanotube wire can have a twisted structure or an untwisted structure. Referring to FIG. 9 and FIG. 3, the untwisted carbon nanotube wire includes a plurality of successively oriented carbon nanotube segments 143 joined end-to-end by van der Waals attractive force. Each carbon nanotube segment 143 includes a plurality of carbon nanotubes 145 parallel to each other, and combined by van der Waals attractive force. The carbon nanotube segments 143 can vary in width, thickness, uniformity and shape. The carbon nanotubes in the untwisted carbon nanotube wire are primarily oriented along one direction (i.e., a direction along the length of the wire). Referring to FIG. 10, the twisted carbon nanotube wire includes a plurality of carbon nanotubes oriented around an axial direction of the carbon nanotube wire. More specifically, the carbon nanotube wire includes a plurality of successive carbon nanotubes joined end to end by van der Waals attractive force. A length and a diameter of the carbon nanotube wire can be set as desired. In the present embodiment, a diameter of the carbon nanotube wire is in a range from 0.5 nanometers to 100 micrometers (µm). A distance between the carbon nanotube wires can range from 0 to 1 millimeter. The carbon nanotubes of the carbon nanotube wire can be semiconducting carbon nanotubes, and can be selected from a group consisting of single-walled carbon nanotubes, double-walled carbon nanotubes, or combination thereof.

It is to be understood that the carbon nanotube wire provides superior toughness, high mechanical strength, and is easy to bend. As such, the semiconducting layer 140 of the present embodiment can be used with a flexible substrate to form a flexible TFT.

A length of the semiconducting layer 140 can be in the range from 1 micron to 100 microns. A width of the semiconducting layer 140 ranges from 1 micron to 1 millimeter. A thickness of the semiconducting layer 140 ranges from 0.5 nanometers to 100 microns. A length of the channel 156 can range from 1 micron to 100 microns. A width of the channel 156 ranges from 1 micron to 1 millimeter. In the present embodiment, the length of the semiconducting layer 140 is 50 microns, the width of the semiconducting layer 140 is 300 microns, the thickness of the semiconducting layer 140 is 1 micron, the length of the channel 156 is 40 microns, and the width of the channel 156 is 300 microns. The semiconducting layer 140 includes one carbon nanotube film. All the carbon nanotubes in the carbon nanotube film are oriented along a direction from the source electrode 151 to the drain electrode 152.

The material of the source electrode 151, the drain electrode 152 and the gate electrode 120 has a good conductive property, and can be selected from a group consisting of pure metals, metal alloys, indium tin oxide (ITO), antimony tin oxide (ATO), silver paste, conductive polymer, metallic carbon nanotubes and combinations thereof. The pure metals and metal alloys can be selected from a group consisting of aluminum, copper, tungsten, molybdenum, gold, cesium, palladium and combinations thereof. A thickness of the source electrode 151, the drain electrode 152 and the gate electrode 120 is 0.5 nanometers to 100 microns. A distance between the source electrode 151 and the drain electrode 152 is 1 to 100 microns.

In one embodiment, when the source electrode 151 and the drain electrode 152 are made of pure metals, metal alloys, indium tin oxide (ITO), or antimony tin oxide (ATO), a conducting layer can be formed by a depositing, sputtering, evaporating method, and etched to form the source electrode 151 and the drain electrode 152. In another embodiment, the source electrode 151 and the drain electrode 152 made of silver paste or conductive polymer can be formed directly by a print method.

In another embodiment, the source electrode 151, the drain electrode 152, and/or the gate electrode 120 comprise a metallic carbon nanotube layer. The metallic carbon nanotube layer includes plurality of metallic carbon nanotubes.

Specifically, the metallic carbon nanotube layer can be a carbon nanotube film or can include a plurality of stacked carbon nanotube films. The carbon nanotube film is formed by a plurality of carbon nanotubes, ordered and has a uniform thickness. The carbon nanotube film is an ordered film. In the ordered film, the carbon nanotubes are primarily oriented along a same direction in each film and parallel to a surface of the carbon nanotube film. Different stratums/layers of films can have the nanotubes offset from the nanotubes in other films. In one embodiment, the ordered carbon nanotube film includes a plurality of successive and oriented carbon nanotubes joined end to end by van der Waals attractive force.

When the carbon nanotube layer includes a plurality of ordered carbon nanotube film, the carbon nanotubes in different carbon nanotube films can be aligned along a same direction, or aligned along a different direction. An angle α between the alignment directions of the carbon nanotubes in each two adjacent carbon nanotube films is in the range 0<α ≦90°.

It is to be understood that, the metallic carbon nanotube layer can include at least one carbon nanotube yarn structure. The carbon nanotube yarn structure includes a plurality of successive and oriented carbon nanotubes joined end to end by van der Waals attractive force. The carbon nanotubes in the carbon nanotube yarn structure are substantially aligned along a length direction of the carbon nanotube yarn structure. The carbon nanotube yarn structure can be twisted or untwisted.

The material of the insulating layer 130 can be a rigid material such as silicon nitride (Si₃N₄) or silicon dioxide (SiO₂), or a flexible material such as polyethylene terephthalate (PET), benzocyclobutenes (BCB), or acrylic resins. A thickness of the insulating layer 130 can be in the range from 5 nanometers to 100 microns. In the present embodiment, the insulating layer 130 is Si₃N₄.

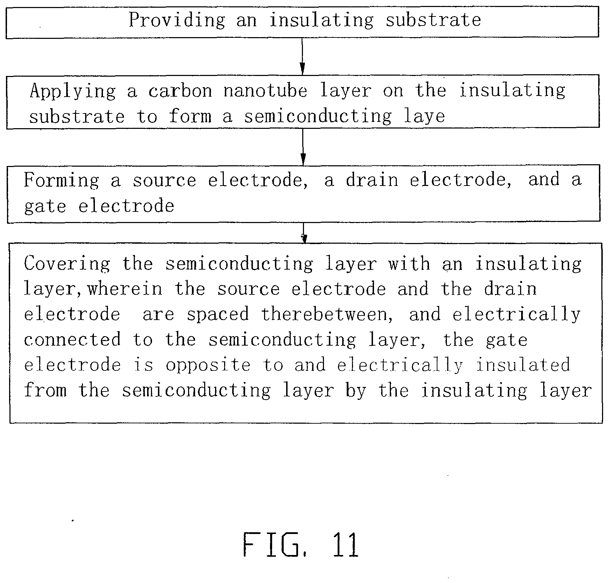

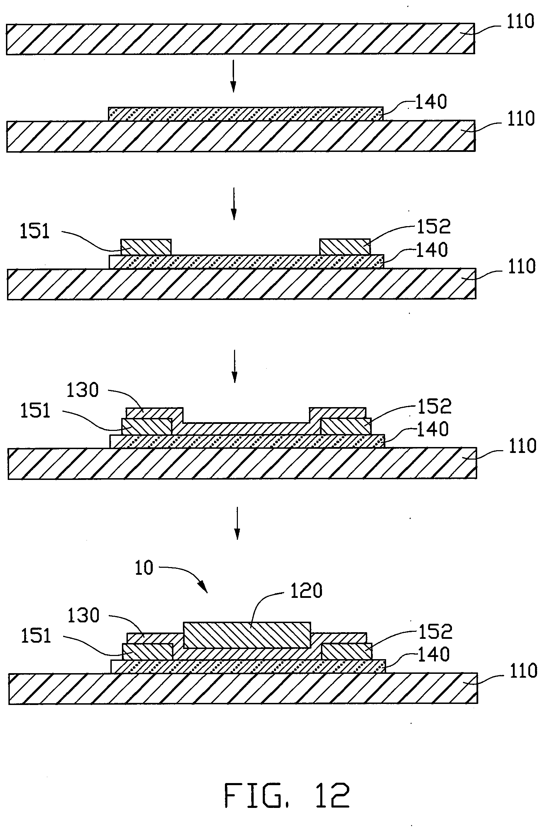

Referring to FIG. 11 and FIG. 12, a method for making a thin film transistor 10 is provided in the first embodiment, and includes the following steps:
(a) providing an insulating substrate 110;
(b) applying a carbon nanotube layer on the insulating substrate 110 to form a semiconducting layer 140;
(c) forming a source electrode 151, a drain electrode 152, and a gate electrode 120;
(d) covering the semiconducting layer 140 with an insulating layer 130,
wherein the source electrode 151 and the drain electrode 152 are spaced therebetween, and electrically connected to the semiconducting layer 140, the gate electrode 120 is opposite to and electrically insulated from the semiconducting layer 140 by the insulating layer 130.

In step (a), the material of the insulating substrate 110 can be the same as a substrate of a print circuit board (PCB), and can be selected from a rigid material (e.g., p-type or n-type silicon, silicon with a silicon dioxide layer formed thereon, crystal, crystal with a oxide layer formed thereon), or a flexible material (e.g., plastic or resin). In the present embodiment, the material of the insulating substrate is polyethylene terephthalate (PET). The shape and size of the insulating substrate 110 is arbitrary.

In step (b), a semiconducting layer 140 can be formed by the following substeps:
(b1) providing a carbon nanotube array;
(b2) pulling out a carbon nanotube film from the carbon nanotube array by using a tool (e.g., adhesive tape, pliers, tweezers, or another tool allowing multiple carbon nanotubes to be gripped and pulled simultaneously);
(b3) placing at least one carbon nanotube film on a surface of the insulating substrate 110.

In step (b1), a super-aligned carbon nanotube array can be used and is formed by the following substeps: (b11) providing a substantially flat and smooth substrate; (b12) forming a catalyst layer on the substrate; (b13) annealing the substrate with the catalyst layer in air at a temperature ranging from 700°C to 900°C for 30 to 90 minutes; (b14) heating the substrate with the catalyst layer to a temperature ranging from 500°C to 740°C in a furnace with a protective gas therein; and (b15) supplying a carbon source gas to the furnace for 5 to 30 minutes and growing the super-aligned carbon nanotube array on the substrate.

In step (b11), the substrate can be a P-type silicon wafer, an N-type silicon wafer, or a silicon wafer with a film of silicon dioxide thereon. In the present embodiment, a 10.16 centimeters (4 inch) P-type silicon wafer is used as the substrate.

In step (b12), the catalyst can be made of iron (Fe), cobalt (Co), nickel (Ni), or any alloy thereof.

In step (b14), the protective gas can be made up of at least one of nitrogen (N₂), ammonia (NH₃), and a noble gas. In step (b15), the carbon source gas can be a hydrocarbon gas, such as ethylene (C₂H₄), methane (CH₄), acetylene (C₂H₂), ethane (C₂H₆), or any combination thereof.

The super-aligned carbon nanotube array can be 200 to 400 microns in height and include a plurality of carbon nanotubes parallel to each other and perpendicular to the substrate. The carbon nanotubes in the carbon nanotube array can be single-walled carbon nanotubes, double-walled carbon nanotubes, or multi-walled carbon nanotubes. Diameters of the single-walled carbon nanotubes range from 0.5 nanometers to 10 nanometers. Diameters of the double-walled carbon nanotubes range from 1 nanometer to 50 nanometers. Diameters of the multi-walled carbon nanotubes range from 1.5 nanometers to 50 nanometers.

The super-aligned carbon nanotube array formed under the above conditions is essentially free of impurities such as carbonaceous or residual catalyst particles. The carbon nanotubes in the super-aligned carbon nanotube array are closely packed together by van der Waals attractive force.

In step (b2), the carbon nanotube film can be formed by the following substeps: (b21) selecting one or more carbon nanotube having a predetermined width from the super-aligned array of carbon nanotubes; and (b22) pulling the carbon nanotubes to form carbon nanotube segments at an even/uniform speed to achieve a uniform carbon nanotube film.

In step (b21), the carbon nanotubes having a predetermined width can be selected by using an adhesive tape such as the tool to contact the super-aligned carbon nanotube array. Each carbon nanotube segment includes a plurality of carbon nanotubes parallel to each other. In step (b22), the pulling direction is arbitrary (e.g., substantially perpendicular to the growing direction of the super-aligned carbon nanotube array).

More specifically, during the pulling process, as the initial carbon nanotube segments are drawn out, other carbon nanotube segments are also drawn out end to end due to van der Waals attractive force between ends of adjacent segments. This process of drawing ensures a substantially continuous and uniform carbon nanotube film having a predetermined width can be formed. The carbon nanotube film includes a plurality of carbon nanotubes joined ends to ends. While there is some variation, the carbon nanotubes in the carbon nanotube film are all substantially parallel to the pulling/drawing direction of the carbon nanotube film, and the carbon nanotube film produced in such manner can be selectively formed to have a predetermined width. The carbon nanotube film formed by the pulling/drawing method has superior uniformity of thickness and conductivity over a typical disordered carbon nanotube film. Further, the pulling/drawing method is simple, fast, and suitable for industrial applications.

The maximum width of the carbon nanotube film depends on a size of the carbon nanotube array. The length of the carbon nanotube film can be arbitrarily set as desired (e.g., 1 centimeter to 100 meters). When the substrate is a 10.16 centimeters (4 inch) P-type silicon wafer, as in the present embodiment, the width of the carbon nanotube film ranges from 0.01 centimeters to 10 centimeters, and the thickness of the carbon nanotube film ranges from 0.5 nanometers to 100 microns.

In step (b3), the carbon nanotube layer is used as a semiconducting layer 140. It is noted that because the carbon nanotubes in the super-aligned carbon nanotube array have a high purity and a high specific surface area, the carbon nanotube film is adherent in nature. As such, the carbon nanotube film can be directly adhered to the surface of the insulating substrate 110. It is noted that, a plurality of carbon nanotube films can be formed in step (b2), and stacked and/or placed side by side on the insulating substrate 110 to form the carbon nanotube layer. Two adjacent carbon nanotube films are combined by van der Waals attractive force therebetween. The aligned direction of the carbon nanotube films is arbitrary. That is, the carbon nanotubes in each carbon nanotube film are aligned along a same direction. The carbon nanotubes in different carbon nanotube films can align along a same direction or different directions.

It is noted that, the carbon nanotube layer, adhered to the surface of the insulating substrate 110, can be treated with an organic solvent. Specifically, the carbon nanotube film can be treated by applying organic solvent to the carbon nanotube film to soak the entire surface of the carbon nanotube film. The organic solvent is volatilizable and can, suitably, be selected from the group consisting of ethanol, methanol, acetone, dichloroethane, chloroform, any appropriate mixture thereof. In the present embodiment, the organic solvent is ethanol. After being soaked by the organic solvent, microscopically, carbon nanotube strings will be formed by adjacent carbon nanotubes, which are able to do so, bundling together, due to the surface tension of the organic solvent. In one aspect, some parts of the carbon nanotubes in the untreated carbon nanotube film that are not adhered on the substrate will come into contact with the insulating substrate 110 after the organic solvent treatment due to the surface tension of the organic solvent. Then the contacting area of the carbon nanotube film with the substrate will increase, and thus, the carbon nanotube film can more firmly adhere to the surface of the insulating substrate 110. In another aspect, due to the decrease of the specific surface area via bundling, the mechanical strength and toughness of the carbon nanotube film are increased and the coefficient of friction of the carbon nanotube films is reduced. Macroscopically, the treated film will be the same uniform carbon nanotube film as the no treated.

In step (c), the material of the source electrode 151, the drain electrode 152, and the gate electrode 120 has a good conductive property, and can be selected from a group consisting of pure metals, metal alloys, indium tin oxide (ITO), antimony tin oxide (ATO), silver paste, conductive polymer, and metallic carbon nanotubes. A thickness of the source electrode 151, the drain electrode 152, and the gate electrode 120 is 0.5 nanometers to 100 microns. A distance between the source electrode 151 and the drain electrode 152 is 1 to 100 microns.

In one embodiment, when the source electrode 151, the drain electrode 152, and the gate electrode 120 are made of pure metals, metal alloys, indium tin oxide (ITO), or antimony tin oxide (ATO), a conducting layer can be formed by a depositing, sputtering, evaporating method, and etched to form the source electrode 151 and the drain electrode 152. In other embodiments, the source electrode 151, the drain electrode 152, and the gate electrode 120 are made of silver paste or conductive polymer can be formed directly by a print method. In other embodiment, carbon nanotube films with metallic carbon nanotubes therein can be separately adhered on the substrate or the carbon nanotube layer 140 to form the source electrode 151 and the drain electrode 152, and can be adhered on the insulating layer 130 to form the gate electrode 120.

In the present embodiment, the source electrode 151 and the drain electrode 152 are separately formed on two ends of the carbon nanotube layer. The carbon nanotubes in the carbon nanotube layer are aligned along a direction from the source electrode 151 to the drain electrode 152, to form a carrier channel from the source electrode 151 to the drain electrode 152.

In the present embodiment, the material of the source electrode 151, the drain electrode 152, and the gate electrode 120 is pure metal, and step (c) can be performed by a lift-off method or an etching method. The thickness of the source electrode 151 and the drain electrode 152 is 1 micron. The distance between the source electrode 151 and the drain electrode 152 is 50 microns.

It is to be understood that, to achieve a semiconducting layer, an additional step (g) of eliminating the metallic carbon nanotubes in the carbon nanotube layer 140 can be further performed before step (d). In one embodiment, the step (g) can be performed by applying a voltage between the source electrode 151 and the drain electrode 152, to break down the metallic carbon nanotubes in the carbon nanotube layer 140, and thereby achieve a semiconducting layer with semiconducting carbon nanotubes therein. The voltage is in a range from 1 to 1000 volts (V). In another embodiment, the step (g) can be performed by irradiating the carbon nanotube layer 140 with a hydrogen plasma, microwave, terahertz (THz), infrared (IR), ultraviolet (UV), or visible light (Vis), to break down the metallic carbon nanotubes in the carbon nanotube layer 140, and thereby achieve a semiconducting layer with semiconducting carbon nanotubes therein.

In step (c), the material of the insulating layer 130 can be a rigid material such as silicon nitride (Si₃N₄) or silicon dioxide (SiO₂), or a flexible material such as PET, benzocyclobutenes (BCB), or acrylic resins. The insulating layer 130 can be depositing, sputtering, evaporating, or printing method according to the material thereof. A thickness of the insulating layer 130 can be in a range from 0.5 nanometers to 100 microns.

In the present embodiment, a Si₃N₄ insulating layer 130 is deposited on the carbon nanotube layer, the source electrode 151, and the drain electrode 152 by a PECVD method. The thickness of the insulating layer 130 is 1 micron.

To be used in a device (e.g., a display), the insulating layer 130 can be further etched to form exposure holes to expose a part of the source electrode 151, and the drain electrode 152.

It is to be understood that the carbon nanotube floccule structure can be directly disposed on the insulating substrate 110 and then pressed to form the carbon nanotube structure.

It is to be understood that the size of the spread carbon nanotube floccule structure is used to control a thickness and a surface density of the carbon nanotube structure and can be adjusted as needed. As such, the larger the area of a given amount of the carbon nanotube floccule structure is spread over, the less the thickness and the density of the carbon nanotube structure.

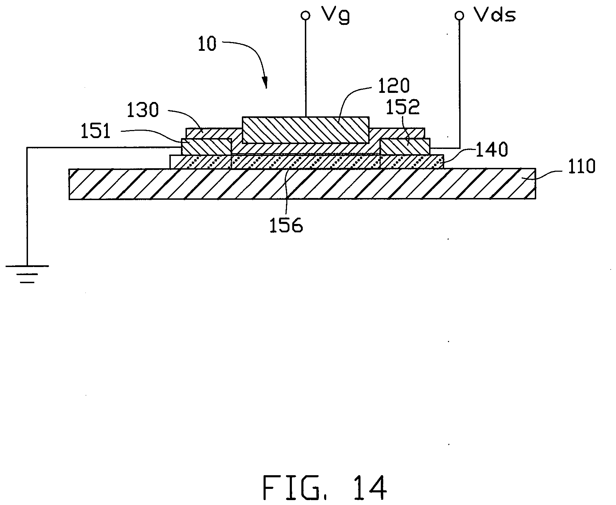

Referring to FIG. 14, in use, the source electrode 151 is grounded. A voltage V_{ds} is applied to the drain electrode 152. Another voltage V_{g} is applied to the gate electrode 120. The voltage Vg forms an electric field in the channel 156 of the semiconducting layer 140. Accordingly, carriers exist in the channel 156 nearing the gate electrode 120. As Vg increases, current can flow from the source electrode 151 to the drain electrode 152 through the channel 156, thus the thin film transistor 10 is in an ON state, the source electrode 151 and the drain electrode 152 are electrically connected. When the semiconducting layer 140 is made of semiconducting carbon nanotube, and the carbon nanotubes are aligned along a direction from the source electrode 151 to the drain electrode 152, the high carrier mobility of the carbon nanotubes along the length direction thereof is very useful in the thin film transistor 10. The carrier mobility of the thin film transistor 10 in the present embodiment is higher than 10 cm²/V⁻¹s⁻¹ (e.g., 10 to 1500cm²/V⁻¹s⁻¹), and the on/off current ratio is in the range from 1.0×10² to 1.0×10⁶.

It is also to be understood that above description and the claims drawn to a method may include some indication in reference to certain steps. However, the indication used is only to be viewed for identification purposes and not as a suggestion as to an order for the steps.

## Claims

1. A thin film transistor (10) comprising:
a source electrode (151);
a drain electrode (152) spaced from the source electrode (151);
a semiconducting layer (140) connected to the source electrode (151) and the drain electrode (152);
an insulating layer (130); and
a gate electrode (120) insulated from the source electrode (151), the drain electrode (152) and the semiconducting layer (140) by the insulating layer (110), wherein the semiconducting layer (140) comprises a carbon nanotube layer **characterized in that** the carbon nanotube layer comprises at least one carbon nanotube film comprising a plurality of successively oriented carbon nanotube segments (143) joined end-to-end by Van der Waals attractive force therebetween, wherein the carbon nanotube segments (143) consist of the plurality of carbon nanotubes (145), wherein the carbon nanotubes (145) have substantially the same length, and adjacent carbon nanotubes (145) of the carbon nanotube segment (143) are combined side by side by Van der Waals attractive force therebetween, wherein the carbon nanotubes (145) in the at least one carbon nanotube film are oriented from the source electrode (151) to the drain electrode (152).

2. A thin film transistor as claimed in claim 1, wherein the carbon nanotube layer comprises at least two of the carbon nanotube films which are stacked and the carbon nanotubes (145) adjacent carbon nanotube films are aligned along a different or the same direction.

3. A thin film transistor as claimed in claim 2, wherein adjacent carbon nanotube films are combined by Van der Waals attractive force therebetween.

4. A thin film transistor as claimed in claim 1, wherein the carbon nanotube layer comprises one of the carbon nanotube films.

## Patentansprüche

1. Ein Dünnfilmtransistor (10), der Folgendes beinhaltet:
eine Zuleitungselektrode (151);
eine Ableitungselektrode (152), die von der Zuleitungselektrode (151) beabstandet ist;
eine Halbleiterschicht (140), die mit der Zuleitungselektrode (151) und der Ableitungselektrode (152) verbunden ist;
eine Isolierschicht (130); und
eine Gateelektrode (120), die von der Zuleitungselektrode (151), der Ableitungselektrode (152) und der Halbleiterschicht (140) durch die Isolierschicht (110) isoliert ist, wobei die Halbleiterschicht (140) eine Kohlenstoffnanoröhrenschicht beinhaltet, **dadurch gekennzeichnet, dass** die Kohlenstoffnanoröhrenschicht mindestens einen Kohlenstoffnanoröhrenfilm beinhaltet, der eine Vielzahl von aufeinanderfolgend ausgerichteten Kohlenstoffnanoröhrensegmenten (143) beinhaltet, die an ihren Enden durch die Van-der-Waals-Anziehungskraft zwischen ihnen verbunden sind, wobei die Kohlenstoffnanoröhrensegmente (143) aus der Vielzahl von Kohlenstoffnanoröhren (145) bestehen, wobei die Kohlenstoffnanoröhren (145) im Wesentlichen die gleiche Länge aufweisen und benachbarte Kohlenstoffnanoröhren (145) des Kohlenstoffnanoröhrensegments (143) Seite an Seite durch die Van-der-Waals-Anziehungskraft zwischen ihnen kombiniert sind, wobei die Kohlenstoffnanoröhren (145) in dem mindestens einen Kohlenstoffnanoröhrenfilm von der Zuleitungselektrode (151) nach der Ableitungselektrode (152) ausgerichtet sind.

2. Dünnfilmtransistor gemäß Anspruch 1, wobei die Kohlenstoffnanoröhrenschicht mindestens zwei der Kohlenstoffnanoröhrenfilme beinhaltet, die gestapelt sind, und wobei die Kohlenstoffnanoröhren (145) benachbarter Kohlenstoffnanoröhrenfilme entlang einer anderen oder der gleichen Richtung ausgerichtet sind.

3. Dünnfilmtransistor gemäß Anspruch 2, wobei benachbarte Kohlenstoffnanoröhrenfilme durch die Van-der-Waals-Anziehungskraft zwischen ihnen kombiniert werden.

4. Dünnfilmtransistor gemäß Anspruch 1, wobei die Kohlenstoffnanoröhrenschicht einen der Kohlenstoffnanoröhrenfilme beinhaltet.

## Revendications

1. Un transistor à couches minces (10) comprenant :
une électrode source (151) ;
une électrode déversoir (152) espacée de l'électrode source (151) ;
une couche semi-conductrice (140) connectée à l'électrode source (151) et à l'électrode déversoir (152) ;
une couche isolante (130) ; et
une électrode de grille (120) isolée de l'électrode source (151), de l'électrode déversoir (152) et de la couche semi-conductrice (140) par la couche isolante (110), la couche semi-conductrice (140) comprenant une couche de nanotubes de carbone, **caractérisé en ce que** la couche de nanotubes de carbone comprend au moins un film de nanotubes de carbone comprenant une pluralité de segments de nanotubes de carbone (143) successivement orientés joints bout à bout par la force d'attraction de Van der Waals entre ceux-ci, les segments de nanotubes de carbone (143) étant constitués de la pluralité de nanotubes de carbone (145), les nanotubes de carbone (145) ayant substantiellement la même longueur, et les nanotubes de carbone (145) adjacents du segment de nanotubes de carbone (143) étant combinés côte à côte par la force d'attraction de Van der Waals entre ceux-ci, les nanotubes de carbone (145) dans l'au moins un film de nanotubes de carbone étant orientés depuis l'électrode source (151) vers l'électrode déversoir (152).

2. Un transistor à couches minces tel que revendiqué dans la revendication 1, dans lequel la couche de nanotubes de carbone comprend au moins deux des films de nanotubes de carbone qui sont empilés et les nanotubes de carbone (145) adjacents à des films de nanotubes de carbone sont alignés en suivant une direction différente ou identique.

3. Un transistor à couches minces tel que revendiqué dans la revendication 2, dans lequel des films de nanotubes de carbone adjacents sont combinés par la force d'attraction de Van der Waals entre ceux-ci.

4. Un transistor à couches minces tel que revendiqué dans la revendication 1, dans lequel la couche de nanotubes de carbone comprend un des films de nanotubes de carbone.
